(19) Europäisches Patentamt

European Patent Office

Office européen des brevets

(11) **EP 0 903 020 B1**

(12) **EUROPÄISCHE PATENTSCHRIFT**

(45) Veröffentlichungstag und Bekanntmachung des Hinweises auf die Patenterteilung:
**25.10.2000 Patentblatt 2000/43**

(21) Anmeldenummer: **97927000.6**

(22) Anmeldetag: **05.06.1997**

(51) Int Cl.$^7$: **H04B 10/152**, H04B 10/155

(86) Internationale Anmeldenummer:
**PCT/DE97/01177**

(87) Internationale Veröffentlichungsnummer:
**WO 97/47099 (11.12.1997 Gazette 1997/53)**

(54) **OPTISCHE SENDEEINRICHTUNG**

OPTICAL TRANSMITTER ARRANGEMENT

DISPOSITIF EMETTEUR OPTIQUE

(84) Benannte Vertragsstaaten:
**DE GB**

(30) Priorität: **05.06.1996 DE 19623883**

(43) Veröffentlichungstag der Anmeldung:
**24.03.1999 Patentblatt 1999/12**

(73) Patentinhaber: **SIEMENS AKTIENGESELLSCHAFT**
**80333 München (DE)**

(72) Erfinder: **STANGE, Herwig**
**D-14167 Berlin (DE)**

(56) Entgegenhaltungen:
**GB-A- 2 276 493**

• **KIMIHIDE MINAKUCHI ET AL: "HIGH-POWER, 790 NM, EIGHT-BEAM ALGAAS LASER ARRAY WITH A MONITORING PHOTODIODE" JAPANESE JOURNAL OF APPLIED PHYSICS, Bd. 31, Nr. 2B, 1.Februar 1992, Seiten 508-512, XP000323476**
• **PATENT ABSTRACTS OF JAPAN vol. 017, no. 156 (E-1341), 26.März 1993 & JP 04 320076 A (SANYO ELECTRIC CO LTD), 10.November 1992,**
• **"SINGLE POWER MONITOR FOR DUAL-BEAM LASER ARRAY" IBM TECHNICAL DISCLOSURE BULLETIN, Bd. 36, Nr. 11, 1.November 1993, Seite 569 XP000424951**

**Beschreibung**

Die Erfindung bezieht sich auf eine optische Sendeeinrichtung mit den Merkmalen des Oberbegriffs des Patentanspruchs 1.

Die Veröffentlichung von K. Minakuchi et al.: "High-Power, 790 nm, Eight-Beam AlGaAs Laser Array with a Monitoring Photodiode" (JJAP Band 31, Seiten 508-512) betrifft eine mehrkanalige optische Sendeeinrichtung der eingangs genannten Art mit einer Monitor-Fotodiode. Diese Sendeeinrichtung umfaßt ein Laser-Array mit acht als Kantenemitter ausgebildeten individuell ansteuerbaren Lasern. Die von jedem Laser frontseitig abgegebene Strahlung dient zur Datenübertragung für je einen Datenkanal, so daß alle Laser des Arrays zur Datenübertragung (als sogenannte Nutzlaser) dienen. Ein rückwärtiger Strahlungsanteil des ersten Nutzlasers gelangt über einen Lichtwellenleiter auf eine rückwärtig angeordnete Fotodiode. Die von der Fotodiode abgegebene Signalspannung, die ein Maß für die abgegebene Strahlung (bzw. den Ansteuerstrom) des ersten Nutzlasers ist, wird den Ansteuerschaltungen der übrigen Laser zugeführt. Die Arbeitspunkte der übrigen Laser werden so in Übereinstimmung mit dem ersten Laser eingestellt.

Eine weitere optische Sendeeinrichtung ist in der GB 2 276 493 A beschrieben. Bei dieser bekannten Sendeeinrichtung ist jedem als kantenmittierender Laser ausgebildeten Halbleiter-Laser einerseits eine Linse und andererseits eine Monitodiode zugeordnet. Mittels der Monitordiode wird eine elektrische Größe erzeugt, die der abgegebenen optischen Leistung des jeweils zugeordneten Lasers proportional ist. Mit dem elektrischen Signal kann mittels einer in der Druckschrift nicht näher dargestellten elektronischen Schaltungsanordnung dafür gesorgt werden, daß der jeweilige Halbleiter-Laser bei Temperaturänderungen und bei Alterung stets eine gleichbleibende Lichtleistung abgibt.

Der Erfindung liegt die Aufgabe zugrunde, eine optische Sendeeinrichtung mit mehreren nebeneinander liegenden Halbleiter-Lasern vorzuschlagen, die einen relativ einfachen Aufbau aufweist und kostengünstig herstellbar ist.

Zur Lösung dieser Aufgabe dient eine Sendeeinrichtung mit den Merkmalen des Patentanspruchs 1.

Ein wesentlicher Vorteil der erfindungsgemäßen Sendeeinrichtung besteht darin, daß bei ihr nicht jeder Halbleiter-Laser mit einer Monitordiode versehen ist, sondern nur dem Überwachungslaser für die gesamte Anordnung der Halbleiter-Laser eine einzige Monitordiode zugeordnet ist. Dadurch läßt sich die erfindungsgemäße Sendeeinrichtung in vergleichsweise einfacher Weise aufbauen, wodurch auch die Herstellungskosten geringer werden. Darüber hinaus muß bei dem Aufbau der erfindungsgemäßen Sendeeinrichtung nicht auf die jeweilige Ausführungsform der Halbleiter-Laser Rücksicht genommen werden, weil beim konstruktiven Aufbau der erfindungsgemäßen Sendeeinrichtung nur darauf geachtet werden muß, daß die Halbleiter-Laser ihr Licht ohne weiteres abgeben können. Schaltungstechnisch ergibt sich bei der erfindungsgemäßen Sendeeinrichtung im Vergleich zu der bekannten Einrichtung kein nennenswert erhöhter Aufwand, weil mit dem Anschluß der Strommeßeingänge an die Halbleiter-Laser nur ein Verdrahtungsaufwand entsteht, der dem bei der bekannten Sendeeinrichtung erforderlichen Aufwand für den Anschluß der verwendeten Monitordioden entspricht. Im übrigen läßt sich die elektronische Schaltungsanordnung bei der erfindungsgemäßen Sendeeinrichtung ohne weiteres als ASIC ausgestalten, bei dem es auf einige zusätzliche Schaltungsdetails bekanntlich nicht ankommt.

Bei der erfindungsgemäßen Sendeeinrichtung kann als Überwachungslaser ein beliebiger Halbleiter-Laser verwendet werden. Als vorteilhaft wird es angesehen, wenn der Überwachungslaser ein Halbleiter-Laser ist, der in seinem elektro-optischen Verhalten weitgehend den Halbleiter-Lasern entspricht. Dieser Forderung kann ohne weiteres dadurch entsprochen werden, daß der Überwachungslaser und die Halbleiter-Laser Bestandteil eines Arrays sind, das von einem Wafer stammt. Dadurch ist der Aufwand für die Bewertung des Stromes durch den Überwachungslaser verhältnismäßig einfach.

Als besonders vorteilhaft wird es angesehen, wenn die Halbleiter-Laser und der Überwachungslaser an einer einzigen Bauteilseite lichtemittierende (VCSEL (Vertical cavity surface emitting laser-)Bauteile sind, weil die Anbringung von Monitordioden an jedem Laser dieser Art besonders aufwendig wäre.

Bei der Bildung der Korrekturgröße in der elektronischen Schaltungsanordnung können neben dem einer vorgegebenen maximal zulässigen optischen Leistung des Überwachungslasers entsprechenden Vorgabewert und dem Sollsignal der Vorstrom der Halbleiter-Laserdioden und auch ihre differentielle Steilheit berücksichtigt werden. Mit ausreichender Näherung an die tatsächlich vorgegebenen Verhältnisse kann eine Korrekturgröße verwendet werden, die in der elektronischen Schaltungsanordnung durch Bildung des Quotienten aus dem Vorgabewert und dem Sollwert gewonnen ist; die Bewertung des gemessenen Stromes durch den Überwachungslaser erfolgt mittels Produktbildung der Korrekturgröße und des gemessenen Stromes durch den überwachungslaser.

Bei der erfindungsgemäßen Sendeeinrichtung sind die Strommeßeingänge der elektronischen Schaltungseinrichtung vorteilhafterweise an in Reihe mit den Halbleiter-Lasern liegenden Widerständen angeschlossen. Derartige Widerstände sind in der Regel stets vorhanden, so daß durch diese Art der Stromerfassung kein zusätzlicher Aufwand entsteht.

Die erfindungsgemäße Sendeeinrichtung kann in vorteilhafter Weise Bestandteil einer optischen Koppelstelle sein, in der der Sendeeinrichtung ein optisches Empfangsteil mit mehreren nebeneinander liegenden und den Halbleiter-Lasern zugeordneten Lichtaufnahmeelementen gegenüber liegt. Eine derartig ausgebildete Sendeeinrichtung ist für sich aus der oben genannten britischen Offenlegungsschrift bekannt.

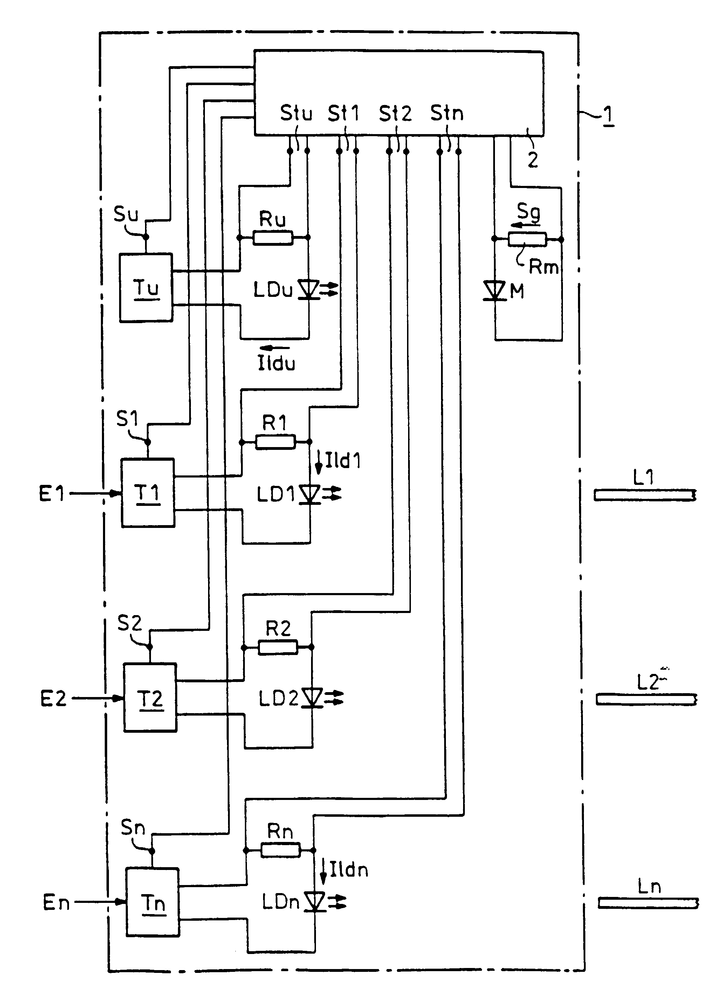

Zur Erläuterung der Erfindung ist in der Figur eine optische Koppelstelle mit einem Ausführungsbeispiel der erfindungsgemäßen Sendeeinrichtung dargestellt.

Wie die Figur im einzelnen erkennen läßt, weist eine optische Sendeeinrichtung 1 Halbleiter-Laser LD1 und LD2 bis LDn auf. Jedem vorzugsweise als VCSEL(Vertical cavity surface emitting laser)-Laserdiode ausgebildeten Halbleiter-Laser LD1 bis LDn ist eine Treiberschaltung T1 und T2 bis Tn vorgeordnet. Mittels dieser Treiberschaltungen T1 bis Tn werden einerseits an Eingängen E1 und E2 bis En der Treiberschaltungen auftretende Impulse zur Datenübertragung und andererseits zusätzlich über weitere Eingänge S1, S2 bis Sn Steuergrößen von einer elektronischen Schaltungsanordnung 2 verarbeitet, mit denen der Strom durch die einzelnen Halbleiter-Laser LD1 bis LDn in seiner Größe gesteuert wird. In Reihe mit den Halbleiter-Lasern LD1 bis LDn liegen Widerstände R1 und R2 bis Rn, die an Strommeßeingänge St1 und St2 bis Stn der elektronischen Schaltungsanordnung 2 angeschlossen sind.

Die Figur läßt ferner erkennen, daß die Sendeeinrichtung 1 einen Überwachungslaser LDu aufweist, der über einen weiteren Widerstand Ru an eine Treiberschaltung Tu ausgangsseitig angeschlossen ist. Diese Treiberschaltung Tu ist über einen Eingang Su mit einem Ausgang der elektronischen Schaltungsanordnung 2 verbunden. Ein Stromerfassungseingang Stu dient zum Erfassen des Spannungsabfalls an dem Widerstand Ru und damit zum Messen des Stromes durch den Überwachungslaser LDu.

Wie die Figur ferner zeigt, ist dem Überwachungslaser Ldu eine Monitordiode M zugeordnet, von der die von dem Überwachungslaser LDu abgegebene optische Leistung erfaßt wird. Es fällt dann an einem in Reihe mit dieser Diode liegenden Widerstand Rm ein elektrisches Signal Sg ab, das ein Eingangssignal für die elektronische Schaltung 2 bildet.

Der Überwachungslaser Ldu und die Monitordiode M dienen nur zur Regelung und Überwachung der Halbleiter-Laser LD1 bis LDn, während die Halbleiter-Laser LD1 bis LDn zur Datenübertragung verwendet werden. Zu diesem Zwecke kann diesen Halbleiter-Lasern jeweils eine lichtleitende Faser L1 und L2 bis Ln nachgeordnet sein, in denen - vorzugsweise unter Zwischenschaltung von optischen Linsensystemen - die von den Halbleiter-Lasern abgegebenen Lichtimpulse aufgenommen und weitergeleitet werden.

Bezeichnet man die von dem Überwachungslaser LDü abgegebene optische Leistung, die aufgrund einer entsprechenden Regelung mit der elektronischen Schaltungsanordnung 2 einer vorgegebenen maximal zulässigen optischen Leistung entspricht, mit Pmax, den Vorstrom durch jeden Halbleiter-Laser LD1 bis LDn mit Ibias(T) - mit T für die jeweilige Temperatur - und die differentielle Steilheit der Halbleiter-Laser mit $\eta(T)$, dann läßt sich der maximal zulässige Strom Imax des jeweiligen Halbleiter-Lasers durch folgende Beziehung (1) ausdrücken:

$$\text{Imax} = \text{Ibias(T)} + \text{Pmax}/\eta \text{ (T))} \tag{1}$$

Dabei läßt sich die differentielle Steilheit durch folgende Gleichung (2) beschreiben:

$$\eta(T) = \text{Psoll} / (\text{Ildn(T)} - \text{Ibias(T)}) \tag{2},$$

in der mit Ildn(T) der jeweilige Strom durch die Halbleiter-Laser LD1 bis LDn bezeichnet ist.

Damit läßt sich die Gleichung (1) unter Berücksichtigung der Gleichung (2) auch in Form der nachstehenden Gleichung (3) beschreiben:

$$\text{Imax} = \text{Ibias(T)} + (\text{Pmax}/\text{Psoll})(\text{Ildn(T)} - \text{Ibias(T)}) \tag{3}$$

Daraus wiederum folgt ohne weiteres die nachstehende Beziehung (4) für den Strom Imax.

$$\text{Imax} = (1-(\text{Pmax}/\text{Psoll}))\text{Ibias (T)} + (\text{Pmax}/\text{Psoll})\text{Ildn(T)} \tag{4}$$

Berücksichtigt man, daß in der Regel die maximal zulässige optische Leistung des Überwachungslasers LDu nahe an der optischen Solleistung der Halbleiter-Laser LD1 bis LDn liegt und der Strom Ildn durch die Halbleiter-Laser LD1 bis LDn wesentlich größer als der Vorstrom Ibias ist, dann läßt sich der erste Ausdruck auf der rechten Seite der obigen Gleichung (4) vernachlässigen, weil er gegen Null geht. Berücksichtigt man ferner, daß die Größe Pmax und die differentielle Steilheit $\eta(T)$ etwa eine ähnliche Temperaturabhängigkeit aufweisen, dann läßt sich der Strom Imax durch folgende Näherungsgleichung (5) beschreiben:

$$Imax = (Pmax/Psoll)Ildn(T) \qquad (5)$$

Es reicht demzufolge aus, bei dem Betrieb der erfindungsgemäßen Sendeeinrichtung mittels der Monitordiode M und des Überwachungslasers LDu die maximal zulässige optische Leistung Pmax konstant zu halten, was über das elektrische Signal Sg mittels der elektronischen Schaltungsanordnung 2 durch entsprechende Ansteuerung des Überwachungslasers LDu erfolgt, um mit der maximal zulässigen optischen Leistung Pmax und der Solleistung Psoll des Überwachungslasers LDu in der elektronischen Schaltungsanordnung eine Korrekturgröße zu bilden, die dem Quotienten aus Pmax und Psoll entspricht; mit dieser Korrekturgröße wird der jeweils gemessene Strom Ildu durch den Überwachungslaser Ldu multipliziert, um Imax zu gewinnen. Stellt sich im Rahmen der Überwachung der Ströme durch die Halbleiter-Laser LD1 bis LDn heraus, daß beispielsweise der Laserstrom Ildl einen Wert annimmt, der dem des Stromes Imax entspricht, dann wird von der elektronischen Schaltungsanordnung 2 über den Eingang S1 der dem Halbleiter-Laser LD1 vorgeordneten Treiberschaltung T1 der Strom durch diesen Halbleiter-Laser auf einen unkritischen Wert vermindert oder dieser Laser überhaupt abgeschaltet. Ist die maximal zulässige optische Leistung Pmax so vorgegeben, daß Augensicherheit gewährleistet ist, dann ist mit der Erfindung eine Sendeeinrichtung geschaffen, die als Laserklasse 1 Produkt klassifiziert werden kann.

## Patentansprüche

1. Optische Sendeeinrichtung mit mehreren nebeneinander liegenden Halbleiter-Lasern, bei der

   - mindestens ein Überwachungslaser (LDu) vorgesehen ist, dessen optische Leistung mittels einer dem Überwachungslaser (LDu) zugeordneten Monitordiode (M) in ein elektrisches Signal (Sg) umgesetzt wird, und die Monitordiode (M) an eine elektronische Schaltungsanordnung (2) angeschlossen ist, die unter entsprechender paralleler Ansteuerung der Halbleiter-Laser (LD1 bis LDn) den Überwachungslaser (LDu) steuert,

   **dadurch gekennzeichnet**, daß

   - die Schaltungsanordnung (2) den Überwachungslaser (LDu) derart steuert, daß das elektrische Signal (Sg) ständig einen einer vorgegebenen maximal zulässigen optischen Leistung (Pmax) des Überwachungslasers (LDu) entsprechenden Vorgabewert aufweist,
   - in der elektronischen Schaltungsanordnung (2) mit dem Vorgabewert des elektrischen Signals (Sg) und mit einem dem Sollwert (Psoll) der optischen Leistung des Überwachungslasers (LDu) entsprechenden Sollsignal eine Korrekturgröße gebildet wird und
   - die elektronische Schaltungsanordnung (2) über Strommeßeingänge (St1 bis Stn) die Ströme durch die Halbleiter-Laser (LD1 bis LDn) und durch den Überwachungslaser (LDu) erfaßt und einen Halbleiter-Laser (z.B. LD1) leistungsmindernd steuert, wenn der durch diesen Halbleiter-Laser fließende Strom (z.B. Ild1) in seiner Größe den mit der Korrekturgröße bewerteten Strom (Ildu) durch den Überwachungslaser (LDu) erreicht.

2. Sendeeinrichtung nach Anspruch 1,
   **dadurch gekennzeichnet**, daß

   - der Überwachungslaser eine Laserdiode ist, die in ihrem elektro-optischen Verhalten weitgehend den Halbleiter-Lasern entspricht.

3. Sendeeinrichtung nach Anspruch 1,
   **dadurch gekennzeichnet**, daß

   - die Halbleiter-Laser (LD1 bis LDn) und der Überwachungslaser (LDu)an einer einzigen Bauteilseite Licht emittierende (VCSEL-)Bauteile sind.

4. Sendeeinrichtung nach einem der vorangehenden Ansprüche,
   **dadurch gekennzeichnet**, daß

   - die Korrekturgröße in der elekronischen Schaltungsanordnung (2) durch Bildung des Quotienten aus dem Vorgabewert (Pmax) und dem Sollwert (Psoll) gewonnen ist und
   - die Bewertung des gemessenen Stromes (z.B. Ild1) durch den jeweiligen Halbleiter-Laser (z.B. LD1) mittels Produktbildung der Korrekturgröße und des gemessenen Stromes (Ildu) durch den Überwachungslaser (Ldu) erfolgt.

5. Sendeeinrichtung nach einem der vorangehenden Ansprüche,
**dadurch gekennzeichnet**, daß

- die Strommeßeingänge (St1 bis Stn) der elektronischen Schaltungsanordnung (2) an in Reihe mit den Halbleiter-Lasern (LD1 bis LDn) liegenden Widerständen (R1 bis Rn) angeschlossen sind.

6. Sendeeinrichtung nach einem der vorangehenden Ansprüche,
**dadurch gekennzeichnet**, daß

- die Sendeeinrichtung (1) Bestandteil einer optischen Koppelstelle ist, in der der Sendeeinrichtung (1) ein optisches Empfangsteil mit mehreren nebeneinanderliegenden und den Halbleiter-Lasern (LD1 bis LDn) zugeordneten Lichtaufnahmeelementen (L1 bis Ln) gegenüberliegt.

**Claims**

1. Optical transmitting device having a plurality of semiconductor lasers lying side by side, in which

- at least one monitoring laser (LDu) is provided, the optical output of which is converted, by means of a monitoring diode (M) associated with the monitoring laser (LDu), into an electrical signal (Sg), and
the monitoring diode (M) is connected to an electronic circuit arrangement (2) which with appropriate parallel activation of the semiconductor lasers (LD1 to LDn) controls the monitoring laser (LDu),

characterised in that

- the circuit arrangement (2) controls the monitoring laser (LDu) in such a way that the electrical signal (Sg) constantly has a predetermined value that corresponds to a predetermined maximum permissible optical output (Pmax) of the monitoring laser (LDu),
- a correction variable is formed in the electronic circuit arrangement (2) with the predetermined value of the electrical signal (Sg) and with a rated signal corresponding to the rated value (Psoll) of the optical output of the monitoring laser (LDu), and
- the electronic circuit arrangement (2), by way of current-measuring inputs (St1 to Stn), measures the currents through the semiconductor lasers (LD1 to LDn) and through the monitoring laser (LDu) and controls a semiconductor laser (for example LD1) in an output-reducing manner if the magnitude of the current (for example Ild1) flowing through this semiconductor laser attains that of the current (Ildu), weighted with the correction variable, through the monitoring laser (LDu).

2. Transmitting device according to claim 1,
characterised in that

- the monitoring laser is a laser diode, the electro-optical behaviour of which largely corresponds to that of the semiconductor lasers.

3. Transmitting device according to claim 1,
characterised in that

- the semiconductor lasers (LD1 to LDn) and the monitoring laser (LDu) are (VCSEL-)components emitting light on one single component side.

4. Transmitting device according to one of the preceding claims, characterised in that

- the correction variable in the electronic circuit arrangement (2) is obtained by forming the quotient of the predetermined value (Pmax) and the rated value (Psoll), and
- the weighting of the measured current (for example Ild1) through the respective semiconductor laser (for example LD1) is effected by forming the product of the correction variable and the measured current (Ildu) through the monitoring laser (Ldu).

5. Transmitting device according to one of the preceding claims, characterised in that

- the current-measuring inputs (St1 to Stn) of the electronic circuit arrangement (2) are connected to resistors (R1 to Rn) connected in series with the semiconductor lasers (LD1 to LDn).

6. Transmitting device according to one of the preceding claims, characterised in that

- the transmitting device (1) is part of an optical coupling point in which an optical receiving portion having a plurality of light-receiving elements (L1 to Ln) lying side by side and associated with the semiconductor lasers (LD1 to LDn) lies opposite the transmitting device (1).

**Revendications**

1. Dispositif optique d'émission ayant plusieurs lasers à semi-conducteur côte à côte, dans lequel

- il est prévu au moins un laser (LDu) de surveillance dont la puissance optique est transformée au moyen d'une diode (M) servant de moniteur associée au laser (LDu) de surveillance en un signal (Sg) électrique, et la diode (M) servant de moniteur est reliée à un montage (2) électronique qui commande, en commandant en parallèle de manière adéquate les lasers (LD1 à LDn) à semi-conducteur, le laser (LDu) de surveillance,

caractérisé en ce que

- le montage (2) commande le laser (LDu) de surveillance de façon que le signal (Sg) électrique comporte en permanence une valeur prescrite correspondant à une puissance (Pmax) optique maximum admissible prescrite du laser (LDu) de surveillance ,
- il est formé dans le montage (2) électronique par la valeur prescrite du signal (Sg) électrique et par un signal de consigne correspondant à la valeur (Psoll) de consigne de la puissance optique du laser (LDu) de surveillance un facteur de correction et
- le montage (2) électronique relève par des entrées (St1 à Stn) de courant les courants qui passent dans les lasers (LD1 à LDn) à semi-conducteur et dans le laser (LDu) de surveillance et commande un laser (par exemple LD1) à semi-conducteur en en diminuant la puissance si l'intensité du courant (par exemple Ild1) passant dans ce laser à semi-conducteur atteint le courant (Ildu) pondéré par le facteur de correction et passant dans le laser (LDU) de surveillance.

2. Dispositif d'émission suivant la revendication 1,
caractérisé en ce que

- le laser de surveillance est une diode laser dont le comportement électro-optique correspond dans une grande mesure à celui des lasers à semi-conducteur.

3. Dispositif d'émission suivant la revendication 1,
caractérisé en ce que

- les lasers (LD1 à LDn) à semi-conducteur et les lasers (LDu) de surveillance sont des éléments émettant de la lumière (VCSEL) d'un seul côté de l'élément.

4. Dispositif d'émission suivant l'une des revendications précédentes,
caractérisé en ce que

- le facteur de correction est obtenu dans le montage (2) électronique en formant le quotient de la valeur (Pmax) prescrite et de la valeur (Psoll) de consigne et
- la pondération du courant (par exemple Ild1) mesuré qui passe dans le laser (par exemple LD1) à semi-conducteur, s'effectue en formant le produit du facteur de correction et du courant (Ildu) mesuré passant dans le laser (LDu) de surveillance.

**5.** Dispositif d'émission suivant l'une des revendications précédentes, caractérisé en ce que

- les entrées (St1 à Stn) de courant du montage (2) électronique sont montées en série avec les résistances (R1 à Rn) des lasers (LD1 à LDn) à semi-conducteur.

**6.** Dispositif d'émission suivant l'une des revendications précédentes, caractérisé en ce que

- le dispositif (1) d'émission fait partie d'un point optique de couplage, dans lequel le dispositif (1) d'émission fait face à une partie optique de réception ayant plusieurs éléments (L1 à Ln) de réception de lumière disposés côte à côte et associés aux lasers (LD1 à LDn) à semi-conducteur.